(19) **Europäisches Patentamt / European Patent Office / Office européen des brevets**

(11) **EP 4 666 329 B1**

(12) # FASCICULE DE BREVET EUROPEEN

(45) Date de publication et mention de la délivrance du brevet:
**05.08.2026 Bulletin 2026/32**

(21) Numéro de dépôt: **24715673.0**

(22) Date de dépôt: **11.03.2024**

(51) Classification Internationale des Brevets (IPC):
*H01M 8/0206* (2016.01)   *H01M 8/0213* (2016.01)
*H01M 8/0228* (2016.01)   *C23C 14/06* (2006.01)
*C23C 14/32* (2006.01)   *C23C 14/54* (2006.01)
*H01M 8/18* (2006.01)   *H01M 8/10* (2016.01)
*C23C 14/02* (2006.01)

(52) Classification Coopérative des Brevets (CPC):
**H01M 8/0206; C23C 14/0605; C23C 14/325;
C23C 14/548; C23C 16/26; H01M 8/0213;
H01M 8/0228;** C23C 14/025; H01M 8/186;
H01M 2008/1095; Y02E 60/50

(86) Numéro de dépôt international:
**PCT/FR2024/050293**

(87) Numéro de publication internationale:
**WO 2024/189288 (19.09.2024 Gazette 2024/38)**

(54) **PIECE REVETUE D'UNE COUCHE A BASE DE CARBONE**

MIT EINER SCHICHT AUF KOHLENSTOFFBASIS BESCHICHTETES TEIL

PART COATED WITH A CARBON-BASED LAYER

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **15.03.2023 FR 2302416**

(43) Date de publication de la demande:
**24.12.2025 Bulletin 2025/52**

(73) Titulaire: **HYDROMECANIQUE ET FROTTEMENT
42160 Andrézieux-Bouthéon (FR)**

(72) Inventeurs:
• **OUGIER, Michaël
42400 SAINT CHAMOND (FR)**
• **LEROY, Marie-Alix
42000 SAINT-ETIENNE (FR)**

(74) Mandataire: **Ipsilon
15 Rue Camille de Rochetaillée
Le Rocacier, CS 70 203
42005 Saint-Etienne Cedex 1 (FR)**

(56) Documents cités:
WO-A1-2008/015016   WO-A1-2017/191370
WO-A1-2021/019084   WO-A1-2021/028399

## Description

### Domaine technique

L'invention se rapporte au domaine technique des revêtements pour électrodes de pile à combustible ou d'électrolyseur.

### Art antérieur

L'invention se rapporte aux systèmes électrochimiques tels que les piles à combustible et les électrolyseurs, et en particulier aux piles à combustible à membrane d'échange de protons, ou « PEMFC » selon l'acronyme anglais pour « proton exchange membrane fuel cells ».

Le fonctionnement de ces systèmes électrochimiques implique un environnement acide ou basique, oxydant à la cathode, une température pouvant être de 60 à 160 °C, et la présence éventuelle d'halogénures. Cet environnement favorise la corrosion des éléments dudit système, tels que les plaques d'interconnexion, désignées également comme les électrodes, les interconnecteurs ou les plaques bipolaires ou monopolaires.

En particulier, les plaques bipolaires sont un des composants critiques pour la durabilité de ces systèmes : elles sont constituées de feuilles métalliques dont l'épaisseur est d'environ 100 μm. Elles doivent être protégées par un revêtement afin de conserver une conduction électrique en surface suffisante pour minimiser les pertes électriques aux interfaces, et afin d'éviter la corrosion des feuilles métalliques dans le milieu agressif de la pile.

La conduction de surface d'une plaque bipolaire réalisée en matériau métallique, y compris en milieu corrosif, est en général obtenue par le dépôt d'une couche fonctionnelle à base de carbone ou d'or sur l'extrême surface d'un substrat. Dans le cas des couches de carbone, le dépôt préalable d'une sous-couche sur le substrat peut améliorer l'adhérence de la couche fonctionnelle et assurer la résistance mécanique de l'empilement.

De manière générale, l'adhérence entre la couche et le substrat, ainsi que la tenue mécanique de la couche fonctionnelle, qui se traduit par une absence d'endommagement par fissuration ou par délamination, sont des paramètres importants.

En effet, la fonction barrière de cette couche ne doit pas se dégrader sur la durée de fonctionnement du système électrochimique, pour protéger le substrat métallique de l'oxydation, afin d'empêcher l'émission dans le milieu de la pile des cations métalliques issus du substrat, même en faible quantité.

Des variations locales et généralement temporaires des conditions du système électrochimique sollicitent de façon accrue la couche fonctionnelle, au sein de laquelle des défauts tels que des manques, fissures, trous, espaces intercolonnaires, peuvent occasionner une dégradation rapide du substrat, notamment par couplage galvanique avec la couche fonctionnelle.

En outre, lorsque la membrane de la pile est en fluoropolymère, elle peut relarguer des ions fluorures F⁻ qui promeuvent entre autres la corrosion par piqûres des substrats d'acier inoxydables. Cela peut ensuite mener à une défaillance rapide et catastrophique de toute la pile.

Afin de protéger une pile de telles défaillances, en répondant aux objectifs de tenue mécanique et de conduction électrique décrits précédemment, il est connu de l'art antérieur de déposer une couche fonctionnelle, notamment à base de carbone.

Le dépôt physique en phase vapeur (ou « PVD » pour l'anglais physical vapor deposition) se caractérise par la possibilité d'obtenir un large éventail de matériaux aux propriétés qui peuvent largement différer, y compris lorsqu'il ne s'agit que de dépôt de carbone, par exemple en jouant sur les proportions d'atomes hybridés sp2 par rapports aux atomes hybridés sp3, il est possible d'obtenir des propriétés d'usage très différentes entre elles.

De manière à améliorer les caractéristiques de la couche déposée, on apporte généralement de l'énergie supplémentaire lors du dépôt. Il est également possible de mettre de plus ou moins grandes proportions d'hydrogène au sein de la couche de carbone.

De bonnes performances ont été obtenues en ajoutant d'autres éléments au carbone. Ainsi, le document WO2011077755 décrit une plaque bipolaire pour pile à combustible revêtue d'une couche fonctionnelle à base de carbone, dopé en azote avec une teneur entre 3 et 20% at., et en hydrogène avec une teneur supérieure à 0% et inférieure ou égale à 20% atomique.

Le document WO2007136131 décrit un organe conducteur doté d'une couche en carbone amorphe, dopé au silicium à une teneur inférieure à 1% at., et contenant de l'hydrogène avec une teneur maximale de 30% at.

Le document WO2013114836 décrit une couche de carbone amorphe contenant de l'hydrogène, de l'azote et de l'oxygène avec des teneurs maximales de 30, 20 et 3% atomiques.

Cependant, le contrôle des teneurs en éléments additionnels alourdit le procédé et rend le traitement plus cher.

Le document JP6512577 décrit un revêtement comprenant deux couches distinctes de carbone amorphe, de différentes natures, et les demandes PCT/FR2022/051631 et PCT/FR2022/051642 au nom du Demandeur fournissent des solutions permettant de satisfaire les exigences du « Department Of Energy » américain (« DOE »). Mais la durée de vie de certains revêtements peut encore être améliorée, notamment à haut potentiel, ou à haute température.

Une difficulté réside enfin dans la contradiction entre avoir une couche la plus mince possible pour que son dépôt soit rapide, et la durabilité plus faible que présente une couche mince, qui va être dégradée plus rapidement.

Un but de l'invention est donc de pallier les inconvénients décrits précédemment.

**Exposé de l'invention**

A cette fin, l'invention vise en premier lieu à proposer un revêtement de carbone dont les caractéristiques intrinsèques sont optimales pour assurer une performance élevée pour des électrodes par exemple de piles à combustible.

Un autre but de l'invention est de proposer un revêtement de carbone dont les caractéristiques intrinsèques sont compatibles avec des systèmes réversibles (« URFC » selon l'anglicisme « Unitised Regenerative Fuel Cell »), qui fonctionnent à un potentiel plus élevé que les PEMFC, ou encore pour des composants de piles à combustible fonctionnant à haute température (« HT PEMFC »), qui fonctionnent entre 120 et 200°C.

L'invention concerne également une pièce adaptée pour les applications particulières de piles à combustible, qui soit performante et peu onéreuse.

L'invention concerne ensuite un procédé de dépôt permettant d'obtenir un tel revêtement de carbone.

À cet effet, il a été mis au point une pièce comprenant un substrat métallique et une couche de matériau à base de carbone amorphe présentant des atomes hybridés sp2 et des atomes hybridés sp3, la couche présentant :

- une première teneur en atomes hybridés sp3 du côté du substrat, et
- une seconde teneur en atomes hybridés sp3 du côté d'une surface externe de la couche, inférieure à la première teneur.

Selon l'invention, une teneur moyenne, au sein de la couche, en liaisons hybridées sp3 est comprise entre 5% et 65%, et de préférence entre 5% et 45%, et la teneur en liaisons hybridées sp3 évolue de manière continue au sein de la couche. Il y a un gradient de la teneur depuis le substrat vers la surface externe. Réciproquement, la teneur en atomes hybridés sp2 montre un gradient inversé au sein de la couche (la somme des teneurs en sp2 et en sp3 vaut 100%).

De cette manière, la couche de matériau à base de carbone présente les caractéristiques intrinsèques optimales pour assurer une performance élevée pour des électrodes. La teneur plus élevée en atomes hybridés sp3 permet de bénéficier, du côté du substrat, des avantages de la forme sp3 du carbone, à savoir sa bonne résistance à l'oxydation et à la dégradation tout en évitant l'inconvénient, du côté de la surface externe, de la résistivité importante de la forme sp3 du carbone grâce à une teneur plus élevée en liaisons sp2.

La pièce selon l'invention présente donc une excellente durée de vie grâce à la résistance de la forme sp3, tout en ayant une faible résistance de contact interfacial et une bonne conductivité de surface grâce à la forme sp2 du carbone.

L'évolution de la teneur en atomes hybridés sp3 au sein de la couche étant continue, ni la distribution des contraintes internes ni le module d'Young au sein de la couche de carbone ne présentent de discontinuité, ou d'interface, qui seraient des sources de dégradations préférentielles, menant par exemple à un écaillage ou à un délaminage.

La cohésion de la couche de carbone est donc améliorée, ce qui contribue à la durabilité de la pièce, notamment en augmentant sa résistance aux phénomènes transitoires.

Dans le cas d'usage particulier au sein d'une pile à combustible, la pièce fait partie d'une plaque du type monopolaire ou bipolaire pour pile à combustible, Dans ce cas, la pièce satisfait les exigences de la DOE.

La teneur moyenne en atomes hybridés sp3 est mesurée par spectrométrie Raman à plusieurs longueurs d'onde d'excitation du laser (325nm, 442nm, 488nm, 633nm). La puissance du laser est limitée, afin d'éviter la modification du matériau sous irradiation. Les spectres d'intensité en fonction du décalage Raman sont ajustés par deux gaussiennes pour les pics G (mode d'élongation) et D (mode de vibration) des liaisons du carbone. Le tracé de la position du pic G (en décalage Raman) en fonction de la longueur d'onde fournit une droite dont la pente est la dispersion du pic G ($cm^{-1}$/nm). Cette dispersion est proportionnelle à la teneur en sp3 du matériau analysé. Un abaque peut être trouvé par exemple dans l'article « Structure of diamondlike carbon films deposited by femtosecond and nanosecond pulsed laser ablation » de Sikora et al., Journal of Applied Physics 108, 113516 (2010).

La teneur locale en atomes hybridés sp3 peut être déterminée grâce à la densité locale du matériau constituant la couche (C). Celle-ci peut être mesurée par microscopie électronique en transmission (« TEM » selon l'anglais « transmission electron microscopy »), sur des coupes transverses grâce à la technique de spectroscopie de perte d'énergie des électrons (« EELS » selon l'anglais « electron energy loss spectroscopy »), et résolue spatialement avec des tailles de faisceau d'électrons limitées à une fraction de nanomètres. Il y a une relation de proportionnalité entre la densité de la couche et la teneur en atomes hybridés sp3 (voir par exemple la publication « Diamond-Like Amorphous Carbon » de J. Robertson, dans Materials Science and Engineering R 37 (2002) 129-281, figure 32).

Selon une autre caractéristique indépendantise des caractéristiques à la base de l'invention, ou bien en combinaison avec les caractéristiques précédentes, du carbone est implanté dans un matériau recevant la couche, qu'il s'agisse du matériau du substrat ou du matériau d'une sous-couche. Cette implantation est obtenue lors du dépôt de la couche, et contribue avantageusement à l'adhérence de la couche sur son support. De manière surprenante, le Demandeur a constaté que l'implantation de carbone, lors d'une phase initiale du dépôt, procurait à la pièce d'excellentes propriétés au regard des exigences précitées.

En d'autres termes, il pourrait tout à fait être envisagé de fournir une pièce comprenant un substrat métallique et une couche de matériau à base de carbone amorphe présentant des atomes hybridés sp2 et des atomes hybridés sp3, la couche présentant :

- une première teneur en atomes hybridés sp3 du côté du substrat, et
- une seconde teneur en atomes hybridés sp3 du côté d'une surface externe de la couche, inférieure à la première teneur ;

dans laquelle du carbone est implanté dans un matériau recevant la couche, qu'il s'agisse du matériau du substrat ou du matériau d'une sous-couche, l'implantation du carbone étant obtenue lors du dépôt de la couche ;
sans de préoccuper de la teneur moyenne, au sein de la couche, en liaisons hybridées sp3 / sp2.

Dans un mode de réalisation préféré, la pièce comprend une unique couche de matériau à base de carbone. Le procédé de fabrication de la pièce ne comprend qu'une seule étape de dépôt de carbone. Il est donc simplifié, et le coût de la pièce est réduit. Encore plus préférentiellement, la pièce comprend une unique couche de matériau constituée uniquement de carbone.

Afin de favoriser la conductivité de la pièce, la teneur moyenne en liaisons hybridées sp3 est limitée. La teneur moyenne en liaisons hybridées sp3 au sein de la couche est donc comprise entre 10% et 45%. De préférence, la teneur moyenne en liaisons hybridées sp3, au sein de la couche, est comprise entre 10% et 30%. Dans certains modes, le matériau forme une couche mince communément appelée « a-C ». Préférentiellement, la teneur en liaisons hybridées sp3 est homogène au sein de la couche, et non localisée au moyen de clusters de cristaux à forte teneur en liaisons hybridées sp3, formant une couche de carbone dont la teneur en liaison hybridées sp3 est hétérogène.

Pour réduire le coût de fabrication de la pièce, le matériau à base de carbone est dépourvu d'élément dopant métallique. De plus, les éléments dopants forment des carbures au sein de la couche de carbone, et ces carbures locaux constituent des sites de défaut et des sites de corrosion préférentiels. Lors du dépôt avec un élément dopant, des gouttelettes métalliques peuvent également se former, et constituer des sites de corrosion préférentiels. De tels inconvénients sont évités.

Les meilleures performances de durabilité, notamment à haut potentiel, ont été obtenues avec des couches de matériau à base de carbone dépourvu d'azote et d'hydrogène.

Par « dépourvu d'hydrogène et d'azote », et « dépourvu d'élément dopant », on signifie que ces éléments ne sont pas ajoutés de manière intentionnelle dans la couche déposée, et ne peuvent être présents qu'en quantité insuffisante pour conférer des propriétés particulières à la couche déposée. De préférence, ces éléments ne sont présents qu'en tant que traces.

Avantageusement, la couche présente une épaisseur supérieure ou égale à 20 nm, de préférence comprise entre 20 nm et 250 nm, plus préférentiellement entre 50 nm et 150 nm, encore plus préférentiellement entre 60 nm et 100 nm.

Pour améliorer l'adhérence de la couche sur la pièce, et pour protéger le substrat d'une éventuelle oxydation, la pièce comprend une sous-couche se trouvant entre le substrat et la couche de matériau à base de carbone, au contact de la couche.

Avantageusement, le matériau de la sous-couche est sélectionné parmi le chrome, titane, zirconium, tantale, niobium, ou leurs alliages ainsi que leurs nitrures et carbures, ou le matériau de la sous-couche est une céramique. De préférence, la sous-couche est un matériau électriquement conducteur, et qui se passive lorsqu'il est soumis à l'oxydation. Le Titane est un matériau préféré.

Afin d'avoir un compromis favorable entre la durée de dépôt de la sous-couche métallique et l'amélioration de l'adhérence qu'elle confère, son épaisseur est comprise entre 5 nm et 200 nm, de préférence entre 20 nm et 100 nm, et vaut par exemple 50 nm.

Dans un mode de réalisation particulier adapté au domaine des piles à combustible, le substrat comprend un acier inoxydable, du titane, un alliage de titane, ou un alliage à base de nickel, de chrome et de fer, qui est de préférence un Inconel®.

De préférence, le substrat est une plaque d'épaisseur comprise entre 10 $\mu$m et 1000 $\mu$m.

De préférence, la pièce fait partie d'une plaque du type monopolaire ou bipolaire pour pile à combustible, car elle présente les caractéristiques techniques lui assurant la durabilité et les performances suffisantes pour satisfaire les exigences du domaine des piles à combustible.

L'invention concerne également un procédé de dépôt sous vide en phase vapeur d'une couche d'un matériau à base de carbone amorphe sur un substrat, remarquable en ce qu'un paramètre influent sur le rapport de liaison hybridée sp2 ou sp3 du carbone varie de manière continue lors du dépôt de la couche de sorte qu'elle présente :

- une première teneur en liaisons hybridées sp3 du côté du substrat, et
- une seconde teneur en liaisons hybridées sp3 du côté d'une surface externe de la couche, inférieure à la première teneur,

et en ce qu'une teneur moyenne au sein de la couche en liaisons hybridées sp3 est comprise entre 5% et 65%, et de préférence entre 5% et 45%,
et en ce que la teneur en liaisons hybridées sp3 évolue de manière continue au sein de la couche.

Par « varie de manière continue », on signifie que le paramètre ne présente pas de discontinuité lors du dépôt, comme lors du dépôt de couches successives distinctes, chacune présentant une teneur en liaisons hybridées sp3 différente. Il peut néanmoins présenter des variations strictement croissantes ou décroissantes, ou bien des variations non strictement croissantes ou décroissantes (oscillations par exemple).

**Brève description des dessins**

[Fig.1] est un schéma d'une coupe d'une pièce selon l'invention.

[Fig.2] est un graphe illustrant la variation de la teneur en atomes de carbone sous forme hybridée sp3 au sein d'une couche de matériau à base de carbone d'une telle pièce.

[Fig.3] est un graphe illustrant la variation de la teneur d'une autre pièce selon l'invention.

[Fig.4] est un graphe illustrant la variation de la teneur d'une autre pièce selon l'invention.

[Fig.5] est un graphe illustrant la variation de la teneur d'une autre pièce selon l'invention.

[Fig.6] est un graphe illustrant la variation de la teneur d'une autre pièce selon l'invention.

[Fig.7] est un graphe illustrant la densité de courant de corrosion lors d'un test.

[Fig.8] est un graphe illustrant la densité de courant de corrosion lors d'un autre test.

[Fig.9] est un graphe illustrant la densité de courant de corrosion lors d'un autre test.

**Description détaillée de l'invention**

Dans le domaine des dépôts sous vide, plusieurs types de technologies existent, et chacune présente ses avantages et ses inconvénients. Dans le cadre du traitement de pièces (P), et en particulier des plaques monopolaires ou bipolaires pour les piles à combustible, le Demandeur a cherché à optimiser des procédés de dépôt connus.

Le Demandeur a effectué différentes séries d'essais et d'interprétations visant à obtenir un dépôt d'un matériau, à base de carbone, formant une couche (C) sur un substrat (S), et présentant de bonnes propriétés notamment de tenue mécanique, de tenue à la corrosion, d'adhérence, et de conduction électrique.

Le dépôt est de préférence réalisé par arc cathodique. Dans ce mode, l'installation utilisée pour mettre en œuvre un mode de réalisation du procédé comprend une enceinte à vide secondaire, munie d'un système de pompage, d'une source plasma, d'une source de pulvérisation par arc, et d'un porte-substrat sur lequel sont montés le ou les substrats (S) à traiter

Le système de pompage permet d'obtenir dans l'enceinte un vide secondaire, c'est-à-dire une pression d'ordre de grandeur compris entre 10-7 mbar et 5x10-5 mbar. Le système de pompage, ou un autre système indépendant, est apte à introduire un gaz dans l'enceinte à vide. Le gaz est destiné à être ionisé, il s'agit préférentiellement d'argon.

La source de pulvérisation par arc est conventionnelle, et est alimentée en régime continu. Alternativement, l'alimentation peut être du type pulsé. Les décharges électriques sur une cible en graphite génèrent des ions carbone.

L'allumage de l'alimentation d'arc peut être intermittent (par exemple 60s d'allumage et 10s d'extinction).

Le porte-substrats est polarisé, c'est-à-dire que l'on applique une tension ou différence de potentiel négative à ses bornes, afin de créer un flux d'ions de carbone en direction du porte-substrats. Cette accélération des ions se produit au voisinage des substrats (S), puisque le champ électrique qui résulte de la polarisation des pièces (P) s'étend sur une distance courte, de l'ordre de quelques millimètres.

Dans le cas de la polarisation d'un substrat (S) dans un plasma, la tension de polarisation est appliquée entre les substrats (S) et la masse de l'installation. Une différence de potentiel s'établit entre les substrats (S) et le plasma. C'est dans cette zone de chute de potentiel, sur environ 0,5 à 2 mm de la surface des substrats (S), que les ions sont accélérés.

Au sein de l'installation, divers tests sont réalisés en modifiant les paramètres de l'épaisseur de la couche (C), la présence ou non d'une sous-couche (SC) entre le substrat (S) et la couche (C), la tension de polarisation (sa valeur, son mode d'application continu ou pulsé, et le rapport cyclique dans le cas d'une tension pulsée), le courant d'allumage de la source (valeur du courant, ou rapport cyclique de l'intermittence).

Les pièces (P) sont revêtues d'une couche (C) fonctionnelle de matériau à base de carbone, destinée à protéger le substrat (S) de l'oxydation pour garantir la durée de vie de la pièce (P), tout en présentant une faible résistance de contact interfacial pour garantir la performance d'une pile ou d'un électrolyseur comprenant la pièce (P).

La durée de vie de la couche (C) déposée est évaluée en lui faisant subir un test de corrosion électrochimique.

Dans des conditions normales de fonctionnement d'une pile, le potentiel à la cathode est inférieur à 0,9V par rapport à une électrode normale à hydrogène dite « NHE » (notation 0,9 V /NHE). Néanmoins, dans des conditions accidentelles et transitoires, l'électrode pourrait subir des potentiels plus élevés, jusqu'à 1,6V/NHE.

C'est le cas notamment au démarrage de la pile ou à l'arrêt de la pile, lors desquels la présence de fronts H2/air ou H2/O2 sur une plaque peut engendrer des phénomènes de courant inverse : la partie alimentée de la pile se décharge dans la partie non alimentée de la pile, engendrant localement des potentiels très élevés (conditions d'électrolyse).

Ces phénomènes transitoires peuvent durer plus longtemps si la pile a été mal drainée après son arrêt (présence d'eau résiduelle), et que la température ambiante est très basse : des canaux de distribution peuvent être bloqués par de la glace issue de l'eau résiduelle, ce qui retarde le remplissage et l'homogénéisation du compartiment.

Il est donc nécessaire que les plaques d'interconnexion puissent résister à des potentiels très élevés, sur des durées de plusieurs heures, par rapport à la durée de vie de la pile. Ceci est d'autant plus important pour des piles pour poids lourds.

Les essais électrochimiques réalisés par le Demandeur sont donc sévérisés par rapport aux exigences du DOE, et se déroulent dans une solution acide de pH égal à 3, à 80°C et avec 0,1ppm d'ion fluorure. Ce milieu de test est défini par le DOE aux Etats-Unis d'Amérique pour simuler le milieu de fonctionnement d'une PEMFC. Dans le cadre des essais présents, le potentiel est fixé à +1,6V/NHE sur l'électrode de travail sur laquelle est monté le matériau à tester. Le potentiel utilisé est supérieur à ce qui est préconisé par le DOE (0,8V/NHE) afin de sévériser le test et de sélectionner uniquement les meilleurs dépôts qui puissent résister à des conditions accidentelles. L'ajout d'un bullage d'air permet de simuler le compartiment cathodique d'une pile à combustible. L'essai est effectué sur une durée de 20h.

Le courant de corrosion est une image de la vitesse de dégradation d'une pièce (P) comprenant un substrat (S) ayant reçu une couche (C) de matériau. En effet, plus le courant de corrosion est élevé, plus la pièce (P) est en train de s'oxyder, c'est-à-dire que la couche (C) de matériau remplit mal son rôle protecteur. En pratique, on considère acceptable une densité de courant de corrosion inférieure à $2000nA/cm^2$ après 20h sous un potentiel de 1,6V/NHE.

La conductivité de surface du revêtement est évaluée par la mesure de sa résistance de contact interfacial, ou « RCI ». Un revêtement présentant une bonne conductivité de surface a une RCI faible, par exemple inférieure à 10 $m\Omega.cm^2$.

La mesure de la RCI est effectuée sur un empilement composé d'un bloc de Cuivre - Feuille de Carbone - Dépôt, sur substrat (S) - Peinture nickel - bloc de Cuivre, sur lequel est appliqué un courant de 100 mA pour une surface de $1 cm^2$, puis la résistance de l'ensemble est calculée à partir de la tension mesurée.

Cet empilement est représentatif du contact entre une plaque bipolaire revêtue et la couche (C) de diffusion de gaz. Une pression de $138N/cm^2$ est appliquée sur celui-ci par un système de bras de levier avec des poids, cette pression étant représentative de celle appliquée sur une cellule électrochimique lors de son assemblage.

La résistance $R_{total}$ obtenue est la somme de l'équation :

- De la résistance du système Cu - Cu

- D'une fois la résistance de contact interfacial Cuivre Carbone $R_{Cu/C}$

- D'une fois la résistance du feutre de Carbone RC

- De la résistance de contact interfacial entre le dépôt et le Carbone $R_{C/dépôt}$.

- De la résistance linéique du dépôt $R_{dépôt}$

- De la résistance de la plaquette en acier 316L $R_{316L}$

- D'une fois la résistance de contact interfacial Nickel Cuivre $R_{Ni/Cu}$

[Math. 1]

$$R_{total} = R_{offset} + R_{Cu/C} + R_{C/dépôt} + R_{dépôt} + R_{Ni/Cu} \qquad (1)$$

La RCI est déterminée à l'aide de l'équation suivante.
[Math. 2]

$$R_{C/dépôt} + R_{dépôt} = RCI = R_{total} - R_{offset} - R_{Cu/C} - R_{Ni/Cu} \qquad (2)$$

Il est pertinent de s'intéresser à la RCI après le test de corrosion sévérisé précédemment décrit. En effet, un substrat (S) revêtu avec une sous-couche (SC) métallique puis une couche (C) de carbone peut présenter une bonne résistance à la corrosion, mais qui peut s'expliquer dans certains cas par une passivation du matériau de la sous-couche (SC) en cas de dégradation de la couche (C) de carbone. Or, ce matériau passivé n'est pas assez conducteur en surface, ce qui signifie qu'une plaque bipolaire fonctionnalisée avec un tel dépôt protège une pile à combustible d'une dégradation accidentelle, cependant la performance de cette pile à combustible serait moindre. La prise en compte cumulative de ces deux paramètres est donc nécessaire.

La sous-couche passivée garantit que l'acier inoxydable du substrat (S) ne va pas émettre des cations métalliques dans le système électrochimique.

Un autre critère est l'aspect visuel de la couche (C), qui ne doit pas avoir été macroscopiquement endommagée, consommée ou délaminée à l'issue de l'essai.

Au sein de l'installation, plusieurs séries d'essais ont été réalisées. Les pièces (P) testées sont des éprouvettes dont le substrat (S) est réalisé en acier inoxydable 316L, destinées à être revêtues sur leurs deux faces, afin de simuler le revêtement de plaques bipolaires.

Le substrat (S) est positionné sur un montage, il est nettoyé et soufflé pour éliminer les contaminants et poussières éventuellement présents à sa surface. Il est ensuite introduit dans une installation de dépôt sous vide.

Le système de pompage est activé afin que la pression dans l'enceinte soit inférieure à 5x10-6 mbar, et l'enceinte est chauffée pour désorber l'eau des parois.

Les surfaces du substrat (S) à revêtir sont chauffées puis bombardées par des ions d'argon afin d'éliminer l'eau adsorbée sur ces surfaces et décaper une couche (C) d'oxyde présente en surface.

Le système de pompage règle ensuite le débit d'argon dans l'enceinte afin qu'il y règne une pression d'argon d'environ 2x10$^{-4}$ mbar pendant la phase de dépôt. L'argon est utilisé afin d'être ionisé, et n'est pas destiné à être contenu dans la couche (C) à base de carbone.

On ne cherche pas à effectuer un dépôt réactif de la couche (C) : le système de pompage n'introduit pas d'azote ni d'autres éléments d'addition dans l'enceinte, tels que des éléments de dopage : le volume intérieur de l'enceinte, et donc la couche (C) déposée, sont exempts d'azote ou d'autres éléments d'addition.

La couche (C) ne contient pas d'hydrogène, d'azote, ou tout autre élément de dopage tel que du tungstène. Dans le domaine technique en question, on entend par « ne contient pas » une teneur nulle, ou une teneur en tant que trace, ou à tout le moins une teneur inférieure à 1%at. Dans tous les cas, on cherche à obtenir une quantité suffisamment faible de ces éléments pour qu'ils ne puissent pas conférer de propriété à la couche (C) déposée. Aucun de ces éléments n'est ajouté de manière intentionnelle lors du dépôt.

Cependant, malgré la chauffe effectuée, il reste toujours un peu d'eau adsorbée au sein de l'enceinte : en pratique, aux pressions de vide de l'ordre de 10$^{-5}$ mbar mises en œuvre, il ne reste quasiment que de la vapeur d'eau au sein de l'enceinte dans la mesure où elle est exempte de fuite notable. Il n'est donc pas possible d'éviter la présence d'oxygène dans l'enceinte au travers de l'eau, et ce composant peut se retrouver dans le dépôt lors de sa formation. De l'oxygène peut également être contenu dans la cible à base de carbone, car la cible de graphite est généralement poreuse.

Contrairement à l'hydrogène, l'oxygène n'est pas facilement ôté de la couche (C) lors du dépôt, et sa teneur dépend des conditions de bombardement ionique appliquées, qui elles-mêmes sont spécifiques à la méthode utilisée. Seul de l'oxygène peut donc être présent dans la couche (C), à l'exception bien entendu d'atomes issus du gaz inerte (argon), qui peuvent être présents en quantités minimes.

Une sous-couche (SC) de matériau métallique peut éventuellement être déposée sur le substrat (S), par exemple par pulvérisation cathodique d'une cible correspondant au matériau désiré (métal ou céramique, éventuellement au sein d'une atmosphère réactive pour modifier la composition de la sous-couche (SC) uniquement).

Ensuite, une couche de matériau à base de carbone est formée à partir d'une cible en graphite par dépôt par arc.

Une première série de tests est effectuée en modifiant :

- la valeur de la tension de polarisation (qu'elle soit continue ou pulsée) ;
- le cas échéant, le rapport cyclique de la tension de polarisation ;
- le rapport cyclique de l'intermittence de l'allumage de la cible en graphite (allumage de l'arc).

Tous les échantillons testés présentent une sous-couche (SC) en titane de 50nm d'épaisseur, et une couche (C) de carbone de 70nm d'épaisseur.

Des caractérisations des pièces (P) ont ensuite été effectuées pour discriminer les différents dépôts obtenus.

A l'issue des essais réalisés, le Demandeur a constaté que malgré le préjugé, par exemple décrit dans les documents WO2022049245A1 et WO202128399A1, qu'une teneur élevée en forme hybridée sp3 serait plus protectrice, certains des échantillons riches en liaisons sp3 (56% de sp3) présentent un courant de corrosion important, ainsi qu'une une forte augmentation de la RCI après test de corrosion : le seul critère de la teneur moyenne en liaisons sp3 ne semble pas suffisant pour discriminer les pièces (P) obtenues.

Par ailleurs, des pièces (P) présentant des teneurs en sp3 modérées présentent des caractéristiques très différentes : un échantillon comprenant en moyenne 20% de liaisons sp3 peut être non conforme, alors qu'un échantillon en comprenant 45% l'est.

De manière inattendue, la présence d'oxygène au sein de la couche (C) n'est pas un critère discriminant.

Dans un premier mode de réalisation, le taux de liaisons sp3 évolue de manière continue au sein de la couche (C), selon un gradient décroissant depuis le substrat (S) vers la surface externe (SE). Cette caractéristique explique pourquoi l'échantillon présentant une teneur moyenne en liaisons sp3 de 45% est conforme, alors que les échantillons présentant des teneurs moyennes de 20% et de 56% ne le sont pas.

En pratique :

- lorsque le dépôt débute, la teneur de sp3 est élevée (donc du côté du substrat (S)) ;
- lors du dépôt, la teneur en sp3 diminue progressivement, sans discontinuité ;
- à la fin du dépôt, la teneur de sp3 est plus faible (donc du côté de la surface externe (SE) de la pièce (P)).

Dans un autre mode de réalisation, le gradient est strictement décroissant depuis le substrat (S), en direction de la surface externe (SE). Par « strictement décroissant », on signifie que la teneur en liaison sp3 ne croît jamais. Un palier de la teneur est toutefois possible. Dans ce mode, la première teneur (sp3%1h) est égale à la teneur maximale en sp3 (sp3% max) au sein de la couche (C), et la seconde teneur (sp3%2b) est la teneur minimale en sp3 (sp3%min).

Dans un autre mode de réalisation, la teneur en liaison sp3 présente des oscillations, de sorte qu'elle croît sur au moins une portion de la couche, selon les variations du paramètre influent. Dans ce mode, la première teneur (sp3%1h) n'est pas la teneur maximale en sp3 (sp3%max) au sein de la couche (C), et la seconde teneur (sp3%2b) n'est pas la teneur minimale (sp3%min).

Dans les deux cas, la teneur en liaison sp3 présente une tendance globale baissière au sein de la couche (C). En effet, une teneur en liaison sp3 plus importante au niveau de la surface externe impliquerait une RCI trop élevée, et une teneur en liaison sp2 trop importante au niveau du substrat impliquerait une mauvaise résistance à la corrosion.

La variation du taux d'hybridation sp3 modifie les caractéristiques de la couche (C). Il est connu qu'une couche de carbone comprenant entre 10% et 35% de liaisons sp3 (le reste étant du sp2) est de la famille des couches de carbone amorphe « a-C », alors qu'une couche de carbone comprenant entre 60% et 85% de sp3 appartient à la famille des couches de carbone à liaison tétraédrique « ta-C », et qu'au sein de la famille des couches de carbone à liaison tétraédrique « ta-C », une couche de carbone comprenant 65% de liaisons sp3 ne présente pas les mêmes caractéristiques (mécaniques, électriques) qu'une couche de carbone comprenant 85% de sp3.

La teneur en liaison sp3 d'un matériau confère donc une nature particulière à ce matériau, et la variation de la teneur en liaison sp3 au sein de la couche (C) permet d'obtenir plusieurs natures de matériaux au sein de la couche.

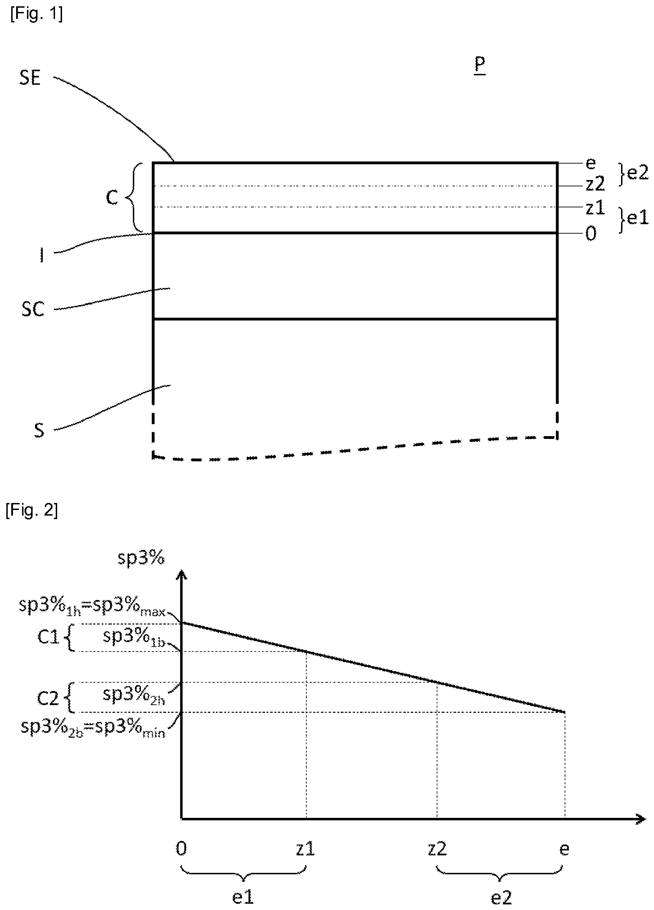

En référence à la figure 1, la pièce (P) présente au sein de la couche (C) de carbone :

- une première zone (e1) du côté du substrat (S), qui est riche en liaison sp3, et au sein de laquelle une première composition (C1) de la couche (C) est majoritairement présente ;
- une seconde zone (e2) du côté de la surface externe (SE), qui est moins riche en liaison sp3, et au sein de laquelle une seconde composition (C2) de la couche (C) est majoritairement présente ;
- la première zone (e1) et la seconde zone (e2) étant séparées par une zone intermédiaire considérée comme négligeable au regard de l'invention.

La première composition correspond à une teneur en liaison sp3 supérieure à un premier seuil (sp3%1b), ou à une teneur en liaison sp3 comprise entre un premier seuil (sp3%1b) et la première teneur (sp3%1h).

La seconde composition correspond à une teneur en liaison sp3 inférieure à un second seuil (sp3%2h), ou à une teneur en liaison sp3 comprise entre la seconde teneur (sp3%2b) et un second seuil (sp3%2h).

La première composition (C1) est par exemple définie par un premier seuil (sp3%1b) de la teneur en liaison sp3, supérieur à 80%, ou à 75%, ou à 70%, ou à 65%, ou à 60%, ou à 55%, ou à 50%, ou à 45%, ou à 40%, ou à 35%, ou à 30%, ou à 25%, ou à 20%, ou à 15%.

La seconde composition (C2) est définie par un second seuil (sp3%$_{2h}$) de la teneur en liaison sp3, inférieur à celle de la première composition (C1), et par exemple inférieur à 4%, ou à 5%, ou à 10%, ou à 15%, ou à 20%, ou à 25%, ou à 30%, ou à 35%, ou à 40%, ou à 45%, ou à 50%, ou à 55%, ou à 60%.

En fonction des valeurs retenues pour la première composition et pour la seconde composition, première zone (e1) et/ou la seconde zone (e2) mesurent chacune entre 1 nm et 30 nm, ou entre 5 nm et 15 nm, ou entre 7 nm et 10 nm.

La première zone (e1), riche en liaison sp3, présente de bonnes caractéristiques mécaniques et de résistance à l'oxydation.

La seconde zone (e2), moins riche en liaison sp3, présente l'intérêt de mieux conduire l'électricité, et implique donc une baisse de la RCI.

La combinaison de ces deux zones, au sein de la même couche (C), permet donc de combiner les avantages de chacune des natures de dépôt. Il est possible de réaliser des couches d'épaisseurs plus faibles que celles de l'art antérieur, à performance équivalente selon les exigences du DOE, voir supérieure aux exigences du DOE puisque l'invention fournit une tenue renforcée à haut potentiel.

Une épaisseur plus faible, outre un temps de dépôt plus court, fournit également une meilleure tenue à la déformation. Si la couche (C) est déposée sur une pièce plane pour être mise en forme ensuite (création de canaux de la plaque bipolaire), la pièce (P) est moins susceptible de présenter des défauts comme des fissures ou délaminations après mise en forme grâce à sa faible épaisseur et grâce à la présence d'une couche riche en sp3 près de l'interface (I) entre la couche (C) et le matériau la recevant.

Par ailleurs, la variation continue de la teneur en liaison sp3 améliore la durabilité de la couche. L'absence de discontinuité :

- permet une meilleure distribution des contraintes internes de la couche (C) de carbone, et évite donc les phénomènes d'écaillage ;
- permet une meilleure cohésion de la matière au sein de la couche (C), et évite donc la présence de sites préférentiels pour les attaques de corrosion.

La variation de la teneur en liaison sp3 est obtenue par la modification d'un paramètre influent lors du dépôt. Par exemple, le paramètre influent peut être la valeur de la tension de polarisation, qu'elle soit continue ou pulsée :

- Il est possible de commencer le dépôt de la couche (C) avec une tension de polarisation adaptée pour que les ions carbone en cours de dépôt soient déposés sur la pièce (P) avec beaucoup d'énergie, favorisant ainsi l'hybridation sp3.
- Lors du dépôt, la tension de polarisation est diminuée progressivement, de sorte que l'énergie d'impact des ions diminue progressivement elle aussi. L'hybridation sp3 est de moins en moins favorisée, de sorte que leur teneur diminue progressivement.

Le paramètre influent est choisi en fonction du procédé de dépôt mis en œuvre, le critère étant la variation continue de la quantité d'énergie apportée lors du dépôt. Par exemple dans le cas de pulvérisation magnétron à régime d'impulsion de haute puissance (HiPIMS), le paramètre influent peut être la quantité d'ions générée par la source plasma, qui dépend des paramètres d'impulsions.

Ou encore, le paramètre influent peut être le courant d'arc appliqué à la cathode, ou le ratio d'allumage d'une polarisation pulsée. Dans le cas d'une tension de polarisation pulsée, on rappelle que pour une valeur moyenne donnée, on alimente le porte-substrats avec une tension inversement proportionnelle à la durée d'allumage. Par exemple :

- pour une tension moyenne de 100V et un ratio d'allumage de 50%, le porte substrat (S) peut être à 0V la moitié du temps, et à 200V l'autre moitié (moyenne de 100V) ;
- pour une tension moyenne de 100V et un ratio d'allumage de 25%, le porte substrat (S) peut être à 0V trois quart du temps, et à 400V un quart du temps (moyenne de 100V).

Bien que la tension moyenne soit identique, on constate que les différences importantes de la tension instantanée modifient l'apport d'énergie aux ions carbone lors du dépôt de la couche (C).

En adaptant la variation du paramètre influent (linéaire ou non), il est possible d'obtenir différents profils de gradients.

En référence aux figures 2 à 4, on a représenté trois profils différents de gradient de la teneur sp3 (sp3%) en fonction de la position au sein de l'épaisseur (e) de la couche (C). En fonction du profil de variation de la teneur, la couche (C) va comprendre une première zone (e1) et une seconde zone (e2) d'épaisseurs variables. La première zone (e1) s'étend depuis l'interface (I) entre la couche (C) et le matériau la recevant, et une première profondeur (z1), la seconde zone (e2) s'étend entre une seconde profondeur (z2) et la surface externe (SE).

La figure 2 illustre un premier exemple dans lequel la teneur en liaison sp3 décroit de manière régulière. Alors la première zone (e1) et la seconde zone (e2) sont d'épaisseurs égales.

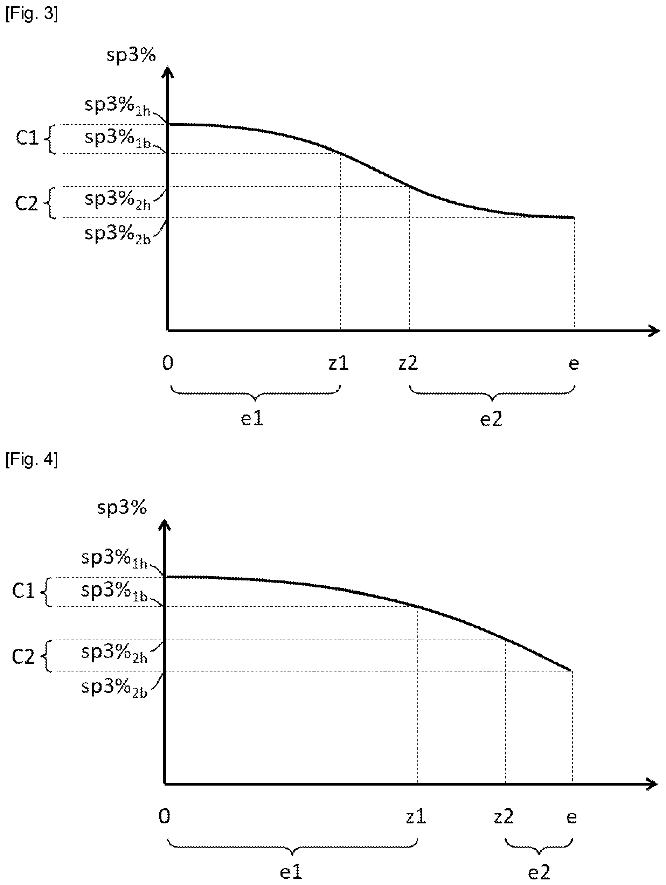

La figure 3 illustre un second exemple dans lequel la teneur en liaison sp3 décroit de manière irrégulière, mais avec un premier palier en début de dépôt et un second palier en fin de dépôt. Ces paliers peuvent être obtenus en stoppant momentanément la variation du paramètre influent. La première zone (e1) et la seconde zone (e2) sont d'épaisseurs égales, car les deux paliers sont de longueurs équivalentes, mais leurs épaisseurs sont plus importantes que dans l'exemple de la figure 2. En revanche, l'épaisseur de la zone intermédiaire est réduite par rapport à celle du premier exemple.

La figure 4 illustre un troisième exemple dans lequel la teneur en liaison sp3 décroit de manière irrégulière, avec uniquement un premier palier en début de dépôt. Alors la première zone (e1) est d'épaisseur plus importante que la seconde zone (e2).

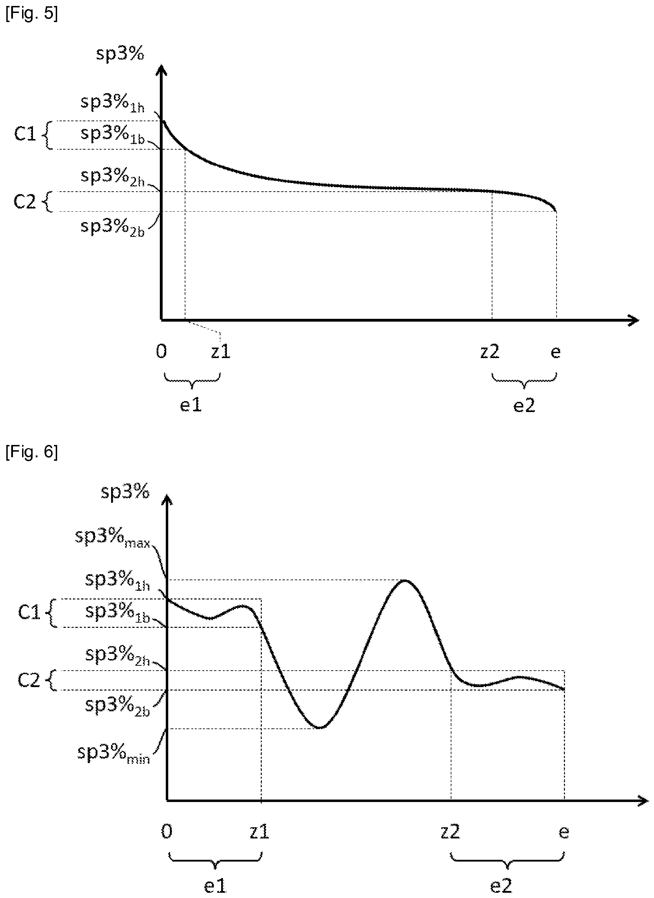

La figure 5 illustre un quatrième exemple, dans lequel la zone intermédiaire constitue la majeure partie de la couche (C), car la première zone (e1) et la seconde zone (e2) sont d'épaisseurs faibles, de l'ordre de quelques nanomètres, par exemple entre 1 nm et 15 nm, ou entre 5 nm et 10 nm.

La figure 6 illustre un cinquième exemple, dans lequel la teneur évolue de manière non-strictement décroissante : des variations du paramètre influent conduisent à des oscillations de la teneur en liaison sp3. Néanmoins la seconde teneur en liaison sp3 (sp3%2b) est strictement inférieure à la première teneur en liaison sp3 (sp3%1h) de manière que la couche (C) présente une première zone (e1) et une seconde zone (e2). Il est possible d'obtenir une zone intermédiaire constituant la majeure partie de la couche (C), en fonction de la tendance baissière de la teneur en liaison sp3, et en fonction de l'amplitude des oscillations. La première zone (e1) et la seconde zone (e2) peuvent être d'épaisseurs faibles, de l'ordre de quelques nanomètres, par exemple entre 1 nm et 20 nm, ou entre 5 nm et 10 nm.

La zone intermédiaire est une zone réalisant une transition entre la première zone (e1) et la seconde zone (e2). Elle comprend de préférence une teneur moyenne en liaison sp3 limitée, afin de maintenir une faible résistivité globale de la couche. Par exemple, la teneur moyenne en liaison sp3, au sein de la couche intermédiaire, est inférieure à 40%, et de préférence inférieure à 25%. Néanmoins, la première teneur en liaison sp3 (sp3%1h) est de préférence d'au moins 30% à 40% afin de protéger le substrat de l'oxydation.

La seconde teneur en liaison sp3 (sp3%2b) quant à elle est de préférence d'au plus 5% à 25%, afin de garantir la bonne conductivité de surface de la pièce (P).

Il est donc possible de favoriser une composition par rapport à l'autre, en adaptant l'épaisseur de la première zone (e1) par rapport à celle de la seconde zone (e2).

La première teneur en liaison sp3 (sp3%1h) est comprise entre 30% et 85%, ou entre 35% et 80%, ou entre 40% et 75%, ou entre 45% et 60%, ou entre 50% et 65%, ou dans toute plage obtenue par la combinaison de ces valeurs.

La seconde teneur en liaison sp3 (sp3%2b) est choisie pour être inférieure à la première teneur (sp3%1h) et est comprise entre 3% et 70%, ou entre 15% et 65%, ou entre 20% et 60%, ou entre 25% et 55%, ou entre 30% et 50%, ou entre 35% et 45%, ou dans toute plage obtenue par la combinaison de ces valeurs.

Le rapport entre la seconde teneur (sp3%2b) et la première teneur (sp3%1h) est compris entre 0,05 et 1 (1 exclu), ou entre 0,2 et 0,9, ou entre 0,3 et 0,8, ou entre 0,4 et 0,7, ou entre 0,5 et 0,6, ou dans toute plage obtenue par la combinaison de ces valeurs.

La teneur moyenne en liaison sp3 de la couche, c'est-à-dire la valeur moyenne de la teneur sur toute l'épaisseur de la couche, est comprise entre 5% et 65%, ou entre 10% et 60%, ou entre 15% et 55%, ou entre 20% et 50%, ou entre 25% et 40%, ou entre 30% et 35%, et vaut par exemple 9%, ou 15%, ou 19%, ou 22%, ou 45%, ou 56%, ou est comprise dans toute plage obtenue par la combinaison de ces valeurs.

En fonction du choix de la première teneur (sp3%1h) et de la seconde teneur (sp3%2b), il est possible d'obtenir :

- une couche (C) de carbone amorphe de type a-C, avec une première teneur de sp3 inférieure à 40% environ ;
- une couche (C) de carbone amorphe de type ta-C, avec une seconde teneur de sp3 supérieure à 60% environ ;
- une couche (C) de carbone présentant :

    * une première zone (e1) riche en liaison sp3, avec une première teneur (sp3%1h) supérieure à 40% environ ; et
    * une seconde zone (e2) riche en liaison sp2 avec une seconde teneur (sp3%2b) inférieure à 40% environ.

Dans un mode de réalisation particulier, pris isolément des caractéristiques à la base de l'invention, ou bien en combinaison, l'énergie des ions est suffisamment élevée pour qu'au niveau de l'interface (I) entre la couche (C) et le matériau support la recevant (qu'il s'agisse du substrat (S) ou de la sous-couche (SC)), du carbone soit implanté au sein de ce matériau.

L'implantation se produit sur une épaisseur de l'ordre de 1 nm à 3nm, par exemple 1,5 nm à 2 nm ou 2,5 nm Ces implantations de carbone permettent de favoriser l'adhérence de la couche (C).

Dans ce mode, l'invention permet de faciliter la fabrication d'une pièce (P) avec une couche (C) présentant à la fois de bonnes performances électriques et électrochimiques, et une bonne adhérence sur la pièce (P), car l'ajustement du niveau d'énergie est configuré à la fois pour implanter du carbone dans la pièce (P) et pour déposer du carbone sous forme de liaison sp3.

La performance d'une pièce (P) correspondant à l'invention a été comparée à celle de dispositifs de l'art antérieur.

Dans ce mode, la pièce (P) est constituée d'un substrat (S) en 316L, d'une sous-couche (SC) de titane mesurant 50nm d'épaisseur, et d'une couche (C) de carbone de 70nm d'épaisseur déposée par arc cathodique, au sein de laquelle la teneur en liaison hybridée sp3 décroît, selon une direction depuis le substrat (S) vers la surface externe (SE).

La couche (C) de carbone ne comprend ni éléments dopants, ni éléments azotés, afin d'éviter la présence de sites préférentiels de corrosion. En revanche, la présence d'oxygène au sein de la couche (C) n'est pas un critère discriminant.

Les échantillons comparatifs sont :

- échantillon comparatif 1 (EC1) : une pièce constituée d'un substrat (S) en 316L, d'une sous-couche (SC) de titane mesurant 50nm d'épaisseur, et d'une couche de carbone ne correspond pas à l'invention, de 70nm d'épaisseur ;
- échantillon comparatif 2 (EC2) : un substrat en 316L, sans revêtement ;
- échantillon comparatif 3 (EC3) : un substrat en titane, sans revêtement.

Des essais de corrosion à potentiel de +1,6V/NHE ont été réalisés.

En référence à la figure 6, la densité de courant de la pièce (P) selon l'invention chute rapidement et est inférieure à 200 nA/cm$^2$ à la fin du test, soit une valeur comparable à celle du substrat titane nu (EC3). Le revêtement est toujours bien présent contrairement à celui de l'échantillon comparatif 1 (EC1) dont la couche (C) de carbone est consommée. A la fin de ce test sévérisé, la RCI de la pièce (P) est faible, ce qui n'est pas le cas du titane nu.

La pièce (P) selon l'invention présente donc à la fois une très bonne conductivité (RCI faible), et une très bonne résistance à l'oxydation (courant de corrosion faible, pas de consommation de la couche (C)).

D'autres essais de corrosion à potentiel de +1,6V/NHE ont été réalisés.

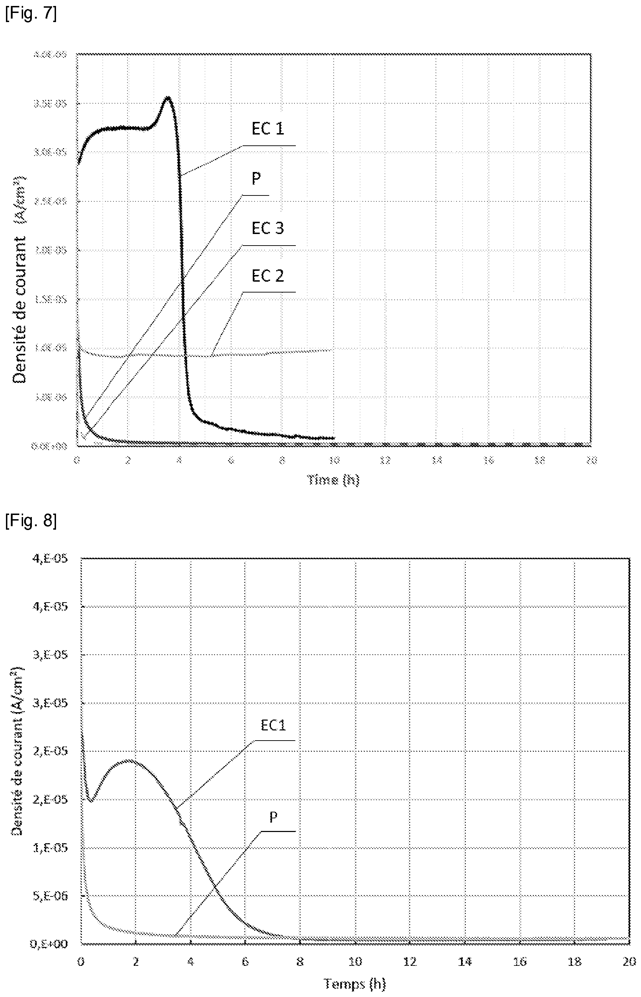

En référence à la figure 7, on a comparé la résistance à la corrosion d'une pièce (P) selon l'invention par rapport à l'échantillon comparatif 1 (EC1).

Les caractéristiques de la teneur en sp3 selon l'invention ont un impact sur la tenue à haut potentiel de la couche (C) :

- la couche (C) de la pièce (P) n'est pas consommée, et la densité de courant de corrosion est très faible ;
- l'échantillon comparatif 1 (EC1) présente un courant de corrosion final faible, mais la couche (C) de carbone est entièrement consommée, et la sous-couche (SC) métallique est mise à nue sur la surface (ce qui correspond au constat d'un courant de corrosion plus important entre 0h et 6h).

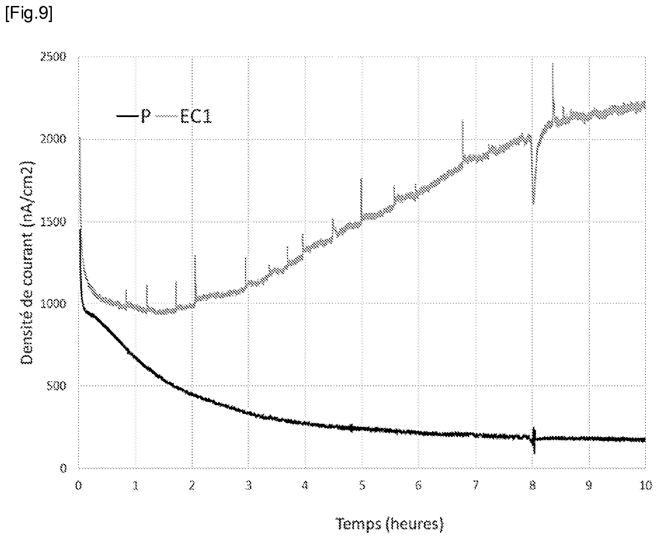

En référence à la figure 9, un autre essai de résistance à la corrosion est mené, cette fois-ci à un potentiel de 1.2V/NHE pendant 10h et à une température de 90°C.

A l'issue de cet autre test sévérisé, on constate une nouvelle fois que la pièce (P) selon l'invention présente une meilleure résistance à la corrosion (environ 10 mΩ.cm$^2$ seulement), que l'échantillon comparatif (EC1) (plus de 100 mΩ.cm$^2$).

L'homme de l'art saura adapter les paramètres de dépôt et en particulier le paramètre influent, en vue de faire évoluer de manière continue la proportion d'atomes hybridés sp3 par rapport aux atomes hybridés sp2, et ainsi se conformer à l'invention.

On rappelle que l'invention présente l'avantage de conférer une plus grande durabilité aux pièces (P), notamment à plus haute température et à plus haut potentiel (qui sont deux conditions sévérisantes par rapport aux conditions standards telles que décrites par la DOE), en comparaison avec les solutions de l'état de l'art des piles à combustible à membrane d'échange de protons.

Par ailleurs, la pièce (P) peut être conformée différemment des exemples donnés sans sortir du cadre de l'invention, qui est défini par les revendications.

Dans certains modes de réalisation, la pièce (P) présente un empilement de plusieurs sous-couches (SC) disposées entre le substrat (S) et la couche (C) externe de matériau à base de carbone.

La couche (C) de carbone est décrite comme étant externe car il s'agit de la couche (C) destinée à être en contact du milieu électrochimique de la pile, et devant assurer à la fois la protection de la pièce (P) contre la corrosion, et favoriser la conduction électrique. Cette terminologie n'exclut pas la présence d'une couche mince de carbone additionnelle, par exemple de type a-C ou a-C :H, déposée pardessus la couche (C) de carbone.

La teneur en liaison sp3 au sein de la couche (C) peut présenter d'autres profils que ceux illustrés.

En outre, les caractéristiques techniques des différents modes de réalisation et variantes mentionnés ci-dessus peuvent être, en totalité ou pour certaines d'entre elles, combinées entre elles. Ainsi, la pièce (P) peut être adaptée en termes de coût, de fonctionnalités et de performance.

## Revendications

1. Pièce (P) comprenant un substrat métallique (S) et une couche (C) de matériau à base de carbone amorphe présentant des liaisons hybridées sp2 et des liaisons hybridées sp3, la couche (C) présentant :

   - une première teneur (sp3%1h) en liaisons hybridées sp3 du côté du substrat (S), et
   - une seconde teneur (sp3%2b) en liaisons hybridées sp3 du côté d'une surface externe (SE) de la couche (C),
   - la première teneur (sp3%1h) étant supérieure à la seconde teneur (sp3%2b),
   *caractérisée en ce qu'*une teneur moyenne au sein de la couche (C) en liaisons hybridées sp3 est comprise entre 5% et 65%, et de préférence entre 5% et 45%,
   *et en ce que* la teneur en liaisons hybridées sp3 évolue de manière continue au sein de la couche (C).

2. Pièce (P) selon la revendication 1, *caractérisée en ce qu'*elle comprend une unique couche (C) de matériau à base de carbone.

3. Pièce (P) selon l'une des revendications précédentes, *caractérisée en ce que* le matériau à base de carbone comprend du carbone sous forme amorphe « a-C ».

4. Pièce (P) selon l'une des revendications précédentes, *caractérisée en ce que* le matériau à base de carbone est dépourvu d'élément dopant.

5. Pièce (P) selon l'une des revendications précédentes, *caractérisée en ce que* le matériau à base de carbone est dépourvu d'azote et d'hydrogène, et encore plus préférentiellement dépourvu d'oxygène.

6. Pièce (P) selon l'une des revendications précédentes, *caractérisée en ce que* le matériau à base de carbone présente une teneur moyenne en liaisons hybridées sp3 comprise entre 10% et 45%, et préférentiellement entre 10% et 30%.

7. Pièce (P) selon l'une des revendications précédentes, *caractérisée en ce que* la couche (C) présente une épaisseur comprise entre 20 nm et 250 nm, de préférence entre 50 et 150nm.

8. Pièce (P) selon l'une des revendications précédentes, *caractérisée en ce qu'*elle comprend une sous-couche (SC) se trouvant entre le substrat (S) et la couche (C) de matériau à base de carbone, au contact de la couche (C).

9. Pièce (P) selon la revendication 8, *caractérisée en ce que* le matériau de la sous-couche (SC) est sélectionné parmi le chrome, titane, zirconium, tantale, niobium, ou leurs alliages ainsi que leurs nitrures, nitrocarbures et carbures, ou le matériau de la sous-couche (SC) est une céramique.

10. Pièce (P) selon l'une des revendications précédentes, *caractérisée en ce que* du carbone est implanté dans un matériau recevant la couche (C).

11. Procédé de dépôt sous vide en phase vapeur d'une couche (C) d'un matériau à base de carbone amorphe sur un substrat (S), *caractérisée en ce qu'*un paramètre influent sur le rapport de liaison hybridée sp2 ou sp3 du carbone varie de manière continue lors du dépôt de la couche (C) de sorte qu'elle présente :

    - une première teneur (sp3%1h) en liaisons hybridées sp3 du côté du substrat (S), et
    - une seconde teneur (sp3%2b) en liaisons hybridées sp3 du côté d'une surface externe (SE) de la couche (C), inférieure à la première teneur (sp3%1h),
    *et en ce qu'*une teneur moyenne au sein de la couche (C) en liaisons hybridées sp3 est comprise entre 5% et 65%, et de préférence entre 5% et 45%,
***et en ce que*** la teneur en liaisons hybridées sp3 évolue de manière continue au sein de la couche (C).

**Patentansprüche**

1. Bauteil (P), umfassend ein metallisches Substrat (S) und eine Schicht (C) aus einem auf amorphem Kohlenstoff basierenden Material mit sp2-hybridisierten Bindungen und sp3-hybridisierten Bindungen, wobei die Schicht (C) aufweist :

   - einen ersten Gehalt (sp3%1h) an sp3-hybridisierten Bindungen auf der Seite des Substrats (S), und
   - einen zweiten Gehalt (sp3%2b) an sp3-hybridisierten Bindungen auf der Seite einer äußeren Oberfläche (SE) der Schicht (C),
   - wobei der erste Gehalt (sp3%1h) größer ist als der zweite Gehalt (sp3%2b),
   ***dadurch gekennzeichnet, dass*** ein mittlerer Gehalt an sp3-hybridisierten Bindungen innerhalb der Schicht (C) zwischen 5 % und 65 %, vorzugsweise zwischen 5 % und 45 %, liegt,
   ***und dass*** sich der Gehalt an sp3-hybridisierten Bindungen innerhalb der Schicht (C) kontinuierlich verändert.

2. Bauteil (P) nach Anspruch 1, **dadurch gekennzeichnet, dass** es eine einzige Schicht (C) aus kohlenstoffbasiertem Material umfasst.

3. Bauteil (P) nach einem der vorhergehenden Ansprüche, **dadurch gekennzeichnet, dass** das kohlenstoffbasierte Material Kohlenstoff in amorpher Form ("a-C") umfasst.

4. Bauteil (P) nach einem der vorhergehenden Ansprüche, **dadurch gekennzeichnet, dass** das kohlenstoffbasierte Material frei von Dotierstoffen ist.

5. Bauteil (P) nach einem der vorhergehenden Ansprüche, **dadurch gekennzeichnet, dass** das kohlenstoffbasierte Material frei von Stickstoff und Wasserstoff und noch bevorzugter frei von Sauerstoff ist.

6. Bauteil (P) nach einem der vorhergehenden Ansprüche, **dadurch gekennzeichnet, dass** das kohlenstoffbasierte Material einen mittleren Gehalt an sp3-hybridisierten Bindungen zwischen 10 % und 45 %, vorzugsweise zwischen 10 % und 30 %, aufweist.

7. Bauteil (P) nach einem der vorhergehenden Ansprüche, **dadurch gekennzeichnet, dass** die Schicht (C) eine Dicke zwischen 20 nm und 250 nm, vorzugsweise zwischen 50 nm und 150 nm, aufweist.

8. Bauteil (P) nach einem der vorhergehenden Ansprüche, **dadurch gekennzeichnet, dass** es eine Unterschicht (SC) umfasst, die zwischen dem Substrat (S) und der Schicht (C) aus kohlenstoffbasiertem Material angeordnet ist und mit der Schicht (C) in Kontakt steht.

9. Bauteil (P) nach Anspruch 8, **dadurch gekennzeichnet, dass** das Material der Unterschicht (SC) aus Chrom, Titan, Zirkonium, Tantal, Niob oder deren Legierungen sowie deren Nitriden, Nitrokarbiden und Karbiden ausgewählt ist, oder dass das Material der Unterschicht (SC) eine Keramik ist.

10. Bauteil (P) nach einem der vorhergehenden Ansprüche, **dadurch gekennzeichnet, dass** Kohlenstoff in ein Material implantiert ist, das die Schicht (C) trägt.

11. Verfahren zur Vakuum-Dampfabscheidung einer Schicht (C) aus einem auf amorphem Kohlenstoff basierenden Material auf einem Substrat (S),

    ***dadurch gekennzeichnet, dass*** ein Parameter, der das Verhältnis von sp2-hybridisierten zu sp3-hybridisierten Bindungen im Kohlenstoff beeinflusst, während der Abscheidung der Schicht (C) kontinuierlich verändert wird, sodass die Schicht aufweist::

    - einen ersten Gehalt (sp3%1h) an sp3-hybridisierten Bindungen auf der Seite des Substrats (S), und
    - einen zweiten Gehalt (sp3%2b) an sp3-hybridisierten Bindungen auf der Seite einer äußeren Oberfläche (SE) der Schicht (C), wobei dieser zweite Gehalt geringer ist als der erste Gehalt (sp3%1h),

*und dass ein* mittlerer Gehalt an sp3-hybridisierten Bindungen innerhalb der Schicht (C) zwischen 5 % und 65 %, vorzugsweise zwischen 5 % und 45 %, liegt,
*und dass* sich der Gehalt an sp3-hybridisierten Bindungen innerhalb der Schicht (C) kontinuierlich verändert.

**Claims**

1. A part (P) comprising a metal substrate (S) and a layer (C) of amorphous carbon-based material having sp2 hybridised bonds and sp3 hybridised bonds, the layer (C) having:

   - a first content (sp3%1h) of sp3 hybridised bonds on the substrate (S) side, and
   - a second content (sp3%2b) of sp3 hybridised bonds on the side of an external surface (SE) of the layer (C),
   - the first content (sp3%1h) being greater than the second content (sp3%2b),
   *characterised in that* an average content within the layer (C) of sp3 hybridised bonds is between 5% and 65%, and preferably between 5% and 45%,
   *and in that* the content of sp3 hybridised bonds evolves continuously within the layer (C).

2. The part (P) according to claim 1, *characterised in that* it comprises a single layer (C) of carbon-based material.

3. The part (P) according to either of the preceding claims, *characterised in that* the carbon-based material comprises carbon in amorphous form, "a-C".

4. The part (P) according to any of the preceding claims, *characterised in that* the carbon-based material is free of dopants.

5. The part (P) according to any of the preceding claims, *characterised in that* the carbon-based material is free of nitrogen and hydrogen, and even more preferentially free of oxygen.

6. The part (P) according to any of the preceding claims, *characterised in that* the carbon-based material has an average content of sp3 hybridised bonds of between 10% and 45%, and preferentially between 10% and 30%.

7. The part (P) according to any of the preceding claims, *characterised in that* the layer (C) has a thickness of between 20 nm and 250 nm, preferably between 50 and 150 nm.

8. The part (P) according to any of the preceding claims, *characterised in that* it comprises an underlayer (SC) which is located between the substrate (S) and the layer (C) of carbon-based material and is in contact with the layer (C).

9. The part (P) according to claim 8, *characterised in that* the material of the underlayer (SC) is selected from chromium, titanium, zirconium, tantalum, niobium, or the alloys thereof and the nitrides, nitrocarbides and carbides thereof, or the material of the underlayer (SC) is a ceramic.

10. The part (P) according to any of the preceding claims, *characterised in that* carbon is implanted in a material receiving the layer (C).

11. A method for the vacuum vapour deposition of a layer (C) of a material based on amorphous carbon on a substrate (S), *characterised in that* a parameter influencing the ratio of sp2 or sp3 hybridised bonds in the carbon varies continuously during the deposition of the layer (C) such that it has:

    - a first content (sp3%1h) of sp3 hybridised bonds on the substrate (S) side, and
    - a second content (sp3%2b) of sp3 hybridised bonds on the side of an external surface (SE) of the layer (C), which second content is lower than the first content (sp3%1h),
    *and in that* an average content within the layer (C) of sp3 hybridised bonds is between 5% and 65%, and preferably between 5% and 45%,
    *and in that* the content of sp3 hybridised bonds evolves continuously within the layer (C).

EP 4 666 329 B1

[Fig. 1]

[Fig. 2]

[Fig. 3]

[Fig. 4]

[Fig. 5]

[Fig. 6]

[Fig. 7]

[Fig. 8]

[Fig.9]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2011077755 A
- WO 2007136131 A
- WO 2013114836 A
- JP 6512577 B
- FR 2022051631 W
- FR 2022051642 W
- WO 2022049245 A1
- WO 202128399 A1

**Littérature non-brevet citée dans la description**

- **SIKORA et al.** Structure of diamondlike carbon films deposited by femtosecond and nanosecond pulsed laser ablation. *Journal of Applied Physics*, 2010, vol. 108, 113516
- **J. ROBERTSON**. Diamond-Like Amorphous Carbon. *Materials Science and Engineering R*, 2002, vol. 37, 129-281